# EUROPEAN PATENT APPLICATION

(11) **EP 1 306 888 A2**
(43) Date of publication of application: **02.05.2003**
(21) Application number: 02016312.7
(22) Date of filing: 24.07.2002
(51) Int. Cl.: H01L 21/00

(54) **Semiconductor processing apparatus for continuously forming semiconductor film on flexible substrate**

(30) Priority: 29.10.2001 JP 2001331382
(71) Applicant: Mitsubishi Heavy Industries, Ltd., Tokyo (JP)
(72) Inventor: Hirai, Etsuro, Mitsubishi Heavy Industr., Ltd., Hiroshima, Hiroshima-ken (JP); Matsuda, Naohiko, Mitsubishi Heavy Industr., Ltd., Hiroshima, Hiroshima-ken (JP)
(74) Representative: Henkel, Feiler, Hänzel

(57) **Abstract**

The present invention provides an apparatus for forming a semiconductor film on a flexible substrate, comprising a supply device (31) for supplying a flexible substrate (32), a recovery device (34) for recovering the flexible substrate (32), a first heating device (36) arranged between the supply device (31) and the recovery device (34) for heating the flexible substrate (32), a PVD device (37) for depositing a film on the substrate (32) by a physical vapor deposition, a CVD device (38) for depositing a film on the substrate (32) by a chemical vapor deposition, a second heating device (39) for heating the material deposited on the substrate (32), and an etching device (40) for etching the material deposited on the substrate (32), wherein the CVD device (38), the second heating device (39) and the etching device (40) are repeatedly arranged within a casing held under a prescribed atmosphere.

## Description

The present invention relates to a semiconductor processing apparatus for continuously forming a semiconductor film on a flexible substrate.

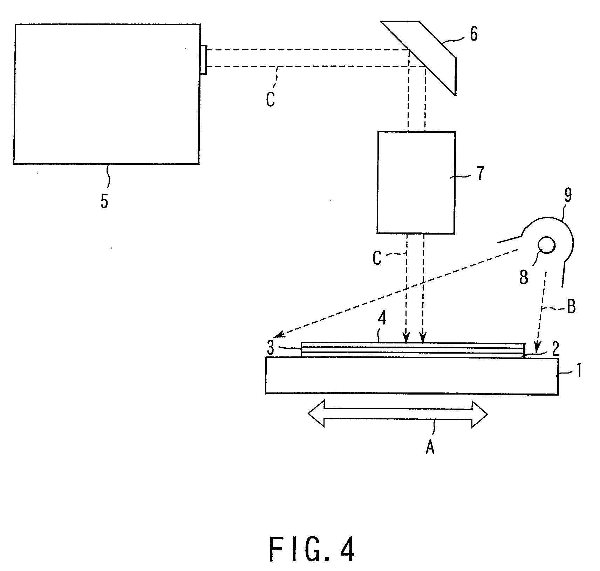

A first prior art as shown in, for example, FIG. 4 is known as a conventional method for forming a semiconductor film on a substrate, as disclosed in Jpn. Pat. Appln. KOKAI Publication No. 8-293466.

A reference numeral 1 shown in FIG. 4 denotes a tray for disposing thereon a planar irradiating substrate 2 to be irradiated with light. The tray 1 is movable in a direction denoted by an arrow A. A base coat film 3 is formed on the irradiating substrate 2, and an amorphous silicon film 4 is formed on the base coat 3. The surface of the irradiating substrate 2 is irradiated with a laser light C emitted from a laser oscillator 5 and having a high energy density. As shown in the drawing, the laser light C passes through a reflector 6 and a beam shaping unit 7 so as to permit the irradiating substrate 2 to be irradiated with the laser light C. On the other hand, an irradiating light B having an energy density lower than that of the laser light C is emitted from a high intensity light unit 9 equipped with an ultraviolet light unit 8 so as to permit the irradiating substrate 2 to be irradiated with the irradiating light B.

As described above, in the first prior art referred to above, the irradiating substrate 2 is irradiated with both the laser light C having a high energy density and the laser light B emitted from the high intensity light unit 9 and having an energy density lower than that of the laser light C so as to heat the amorphous silicon film 4 formed on the base coat film 3 and, thus, to convert the amorphous silicon film 4 into a polycrystalline silicon (polysilicon) film.

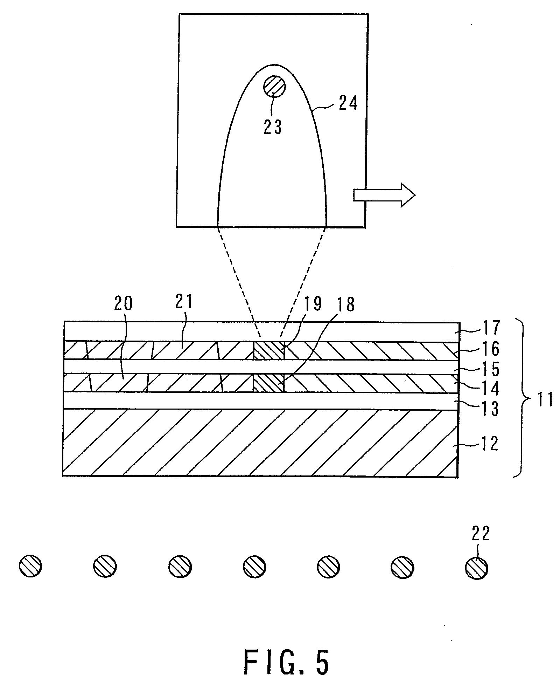

A second prior art shown in FIG. 5, which is disclosed in Japanese Patent Disclosure No. 10-270359, is also known as a conventional method for forming a semiconductor thin film on a substrate.

A reference numeral 11 shown in FIG. 5 denotes a sample. As shown in the drawing, the sample 11 is constructed such that an insulating film 13, a thin film semiconductor film 14, an insulating film 15, a thin film semiconductor film 16 and an insulating film 17 are formed in the order mentioned on a planar substrate 12. It should be noted that molten portions 18 and 19 are formed in the thin semiconductor films 14 and 16, respectively. In addition, recrystallized semiconductor portions 20 and 21 are also formed in the thin semiconductor films 14 and 16, respectively.

A base heating source 22 for performing the function of heating the entire sample 11 is arranged below the sample 11. Also, a melt heating source 23 is arranged above the sample 11. The infrared rays generated from the melt heating source 23 pass through an elliptical mirror 24 so as to be converged on a prescribed portion on the sample 11.

In the apparatus of the construction described above, the temperature of the melt heating source 23 such as an infrared halogen lamp is elevated under the state that the temperature of the base heating source 23 is elevated so as to heat the entire sample 11 to a temperature not higher than the melting point of silicon, e.g., 100°C to 1,400°C. The infrared rays generated by the heating of the melt heating source 23 are focused by the elliptical mirror 24 so as to heat and melt dot-like points of the thin semiconductor films 14 and 16 that are to be melted for recrystallization, thereby forming the molten portions 18 and 19.

As described above, in each of the first and second prior arts, a semiconductor film, which is not of a single crystalline structure, is irradiated with a laser light or an electron beam so as to increase the crystal grain size of the thin film, to convert the crystal structure into a single crystalline structure, to laminate thin films, or to carry out a lithography. However, each of these prior arts is directed to a process that is carried out on a rigid planar substrate. What should be noted is that an apparatus for forming a semiconductor film on a flexible substrate has not yet been developed. In addition, the prior art is directed to an apparatus for carrying out the processing on the basis of a batch system in which the substrate such as a semiconductor wafer is processed one by one. In other words, the conventional apparatus is incapable of performing a continuous processing efficiently.

An object of the present invention is to provide an apparatus for forming a semiconductor film continuously on a flexible substrate, which permits continuously performing a series of steps ranging between the formation of an amorphous silicon thin film on a flexible substrate and the recrystallization of the amorphous silicon thin film to form a laminate structure of single crystalline silicon films.

According to one embodiment of the present invention, there is provided an apparatus for forming a semiconductor film on a flexible substrate, comprising a supply device for supplying a flexible substrate; a recovery device for recovering the flexible substrate; a first heating device arranged between the supply device arid the recovery device for heating the substrate; a PVD device for depositing a film on the substrate by a physical vapor deposition; a CVD device for depositing a film on the substrate by a chemical vapor deposition; a second heating device for heating the material deposited on the substrate; and an etching device for etching the material deposited on the substrate, wherein the CVD device, the second heating device and the etching device are repeatedly arranged within a casing held under a prescribed atmosphere.

This summary of the invention does not necessarily describe all necessary features so that the invention may also be a sub-combination of these described features.

The invention can be more fully understood from the following detailed description when taken in conjunction with the accompanying drawings, in which:
FIG. 1 schematically shows the apparatus for forming a semiconductor film on a flexible substrate according to one embodiment of the present invention;
FIG. 2 shows in a magnified fashion a gist portion of the apparatus shown in FIG. 1;
FIG. 3 shows in a magnified fashion a gist portion of the apparatus shown in FIG. 2;
FIG. 4 schematically shows a conventional apparatus for forming a semiconductor film; and
FIG. 5 schematically shows another conventional apparatus for forming a semiconductor film.

The apparatus of the present invention for forming a semiconductor film on a flexible substrate comprises a supply device for supplying a flexible substrate; a recovery device for recovering the flexible substrate; a first heating device arranged between said supply device and said recovery device for heating said substrate; a PVD device for depositing a film on said substrate by a physical vapor deposition; a CVD device for depositing a film on said substrate by a chemical vapor deposition; a second heating device for heating the material deposited on said substrate; and an etching device for etching the material deposited on said substrate, wherein said CVD device, said second heating device and said etching device are repeatedly arranged within a casing held under a prescribed atmosphere.

In the apparatus of the present invention for forming a semiconductor film on a flexible substrate, a radiation heat type or a laser type heating device is used as the second heating device, and an optical etching device is used as the etching device.

Also, in the apparatus of the present invention for forming a semiconductor film on a flexible substrate, an exhaust chamber is arranged between the first heating device and the PCD device, between the PVD device and the CVD device, between the DVD device and the second heating device, and between the second heating device and the etching device.

Also, in the apparatus of the present invention for forming a semiconductor film on a flexible substrate, a floating roll for determining the position of the flexible substrate is arranged between the first heating device and the PVD device, between the PVD device and the CVD device, between the CVD device and the second heating device, and between the second heating device and the etching device.

Also, in the apparatus of the present invention for forming a semiconductor film on a flexible substrate, the flexible substrate is formed of any of a thin metal sheet and a thin plastic sheet.

Also, in the apparatus of the present invention for forming a semiconductor film on a flexible substrate, a roll for applying each processing to the flexible substrate is arranged in each of the chambers housing the first heating device, the PVD device, the CVD device, the second heating device, and the etching device. Also, the roll noted above has a surface roughness not larger than 0.3 µm.

The present invention will now be described more in detail.

The present invention covers the case where the second heating device is a radiation heat type or laser type heating device, and the etching device is an optical etching device.

In the present invention, it is desirable to arrange an exhaust chamber between the first heating device and the PVD device, between the PVD device and the CVD device, between the CVD device and the second heating device, and between the second heating device and the etching device. The exhaust chamber thus arranged permits avoiding the mixing of the process gasses supplied to the process chambers.

In the present invention, it is desirable to arrange a floating roll for determining the position of the flexible substrate between the first heating device and the PVD device, between the PVD device and the CVD device, between the CVD device and the second heating device, and between the second heating device and the etching device. The floating roll thus arranged permits determining the position for applying the processing to the flexible substrate.

In the present invention, the flexible substrate is formed of a thin metal sheet such as a thin stainless steel sheet or a thin plastic sheet. The particular thin sheet is excellent in the ductility and in the heat resistance or heat insulating properties. It follows that the flexible substrate formed of the particular thin sheet is adapted for the process such as a local heating.

In the present invention, it is desirable to arrange a roll for applying each processing to the flexible substrate in each of the chambers housing the first heating device, the PVD (physical vapor deposition) device, the CVD (chemical vapor deposition) device, the second heating device, and the etching device. It is also desirable for the surface roughness of the roll to be set at a level not higher than 0.3 µm. Where the surface roughness of the roll is set at a level not higher than 0.3 µm, it is possible to maintain uniform the temperature of the flexible substrate and to make uniform the contact heat transmission to the substrate. If the surface roughness of the roll exceeds 0.3 µm, it is impossible to obtain sufficient effects.

The present invention provides an apparatus for forming continuously a semiconductor film on a flexible substrate in place of the conventional apparatus for forming a semiconductor film on a batch system. The apparatus of the present invention permits consecutively performing a series of steps ranging between the step of forming an amorphous silicon thin film on a flexible substrate and the step of crystallizing the amorphous silicon thin film so as to form a multi-layer structure consisting of a plurality of single crystalline silicon films on the flexible substrate.

To be more specific, the present invention provides an apparatus for forming a semiconductor film on a flexible substrate, which permits producing various effects, including, for example, that (1) it is possible to prevent an unnecessary gaseous components from being carried into the process chamber, (2) a series of process steps can be carried out while preventing the laminate structure of the semiconductor films from being contaminated with the air, (3) the process position can be determined by the fine adjustment of the floating roll, (4) the process chamber gas can be prevented from entering the exhaust chamber gas on the side of the front stage and the exhaust chamber gas on the side of the rear stage so as to permit the waste process chamber gas to be evacuated efficiently, (5) the flexible substrate passing along the outer circumferential surface of the process roll can be heated to the temperature required for the processing, (6) the unnecessary gas or the like after the processing in each process section can be evacuated to the outside through an exhaust port so as to decrease the amount of the waste gas in the exhaust chamber, (7) even if the amount of the thermal expansion of the flexible substrate within a certain process chamber differs from that in another process chamber, it is possible for the floating roll to prevent the change in the position determination, and (8) the flexible substrate is excellent in the ductility and in the heat resistance or the heat insulating properties and, thus, the flexible substrate used in the present invention is adapted for the process such as a local heating process.

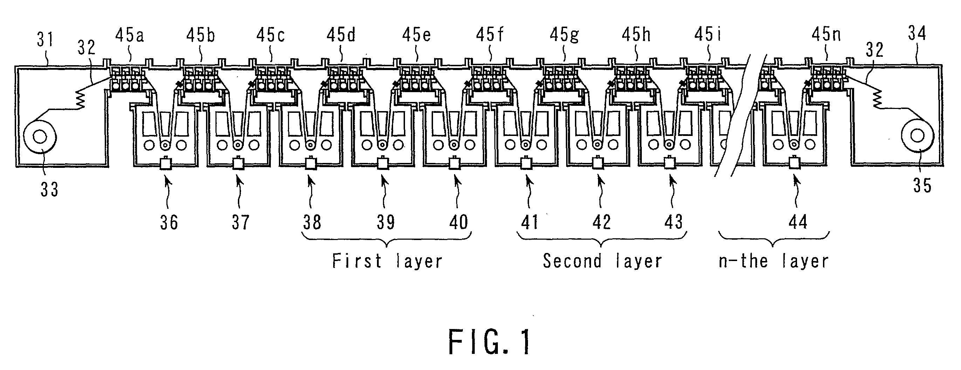

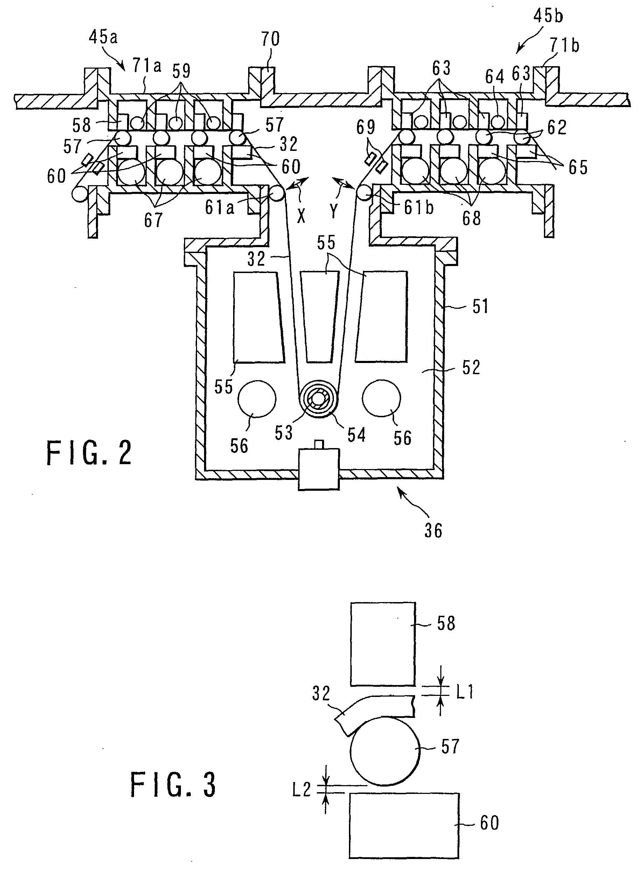

The apparatus of the present invention for forming a semiconductor film on a flexible substrate will now be described in detail with reference to FIGS. 1 to 3, wherein FIG. 1 schematically shows the entire construction of an apparatus for forming a semiconductor film on a flexible substrate, FIG. 2 shows in a magnified fashion a gist portion of the apparatus shown in FIG. 1, and FIG. 3 shows in a magnified fashion a gist portion of the apparatus shown in FIG. 2.

The apparatus of the present invention for forming a semiconductor film on a flexible substrate is housed in a series of continuous casings in which a prescribed atmosphere is maintained. As shown in FIG. 1, the semiconductor film forming apparatus comprises a pay-off section 31, which is arranged on the side of one end of the semiconductor film forming apparatus and used as a supply device for supplying a flexible substrate 32 formed of a polyimide film into each process section, and a wind-up section 34, which is arranged on the side of the other end of the semiconductor film forming apparatus and used as a recovery device for recovering the flexible substrate. The pay-off section 31 comprises a pay-off reel 33 held under a clean atmosphere free from dust for winding up the flexible substrate 32. On the other hand, the wind-up section 34 comprises a wind-up reel 35 arranged under a clean atmosphere free from dust for winding up the processed flexible substrate 32.

Arranged between the pay-off section 31 and the wind-up section 34 are a first heating device 36, a PVD device 37, CVD devices 38, 41, laser type second heating devices 39, 42, optical etching devices 40, 43 and an additional treatment device 44. The first heating device 36 performs the function of heating the flexible substrate 32. The PVD device 37 performs the function of physically depositing a film on the flexible substrate 32 by a physical vapor deposition. The CVD devices 38 and 41 perform the function of depositing a film on the flexible substrate 32 by a chemical vapor deposition. The second heating devices 39 and 42 perform the function of heating the material deposited on the flexible substrate 32. Further, the optical etching devices 40 and 43 perform the function of etching the material deposited on the flexible substrate 32. It should be noted that the CVD devices, the second heating devices and the etching devices are repeatedly arranged n-times in the direction of the flow of the flexible substrate 32. Each of these devices 36 to 43 is held under the atmosphere required for each processing.

For example, the deposition of a first semiconductor film on the flexible substrate 32, the annealing of the first semiconductor film by irradiation with a laser beam (or EB), and the laser etching are performed by the CVD device 38, the second heating device 39 and the etching device 40, respectively. Also, the deposition of a second semiconductor film on the flexible substrate 32, the annealing of the first semiconductor film by irradiation with a laser beam (or EB), and the laser etching are performed by the CVD device 41, the second heating device 42 and the etching device 43, respectively. In this fashion, various types of processing are successively applied to the semiconductor films formed on the flexible substrate so as to finally apply various types of processing to the n-th semiconductor film formed on the flexible substrate. Further, the flexible substrate 32 having an additional treatment applied thereto in the final stage is wound up by the wind-up reel 35 arranged in the wind-up section 32.

It should be noted that exhaust sections 45a, 45b, 45c, 45d, 45e, 45f, 45g, 45h, 45i, ... 45n are arranged between adjacent process sections, i.e., between the pay-off section 31 and the first heating device 36, between the first heating device 36 and the PVD device 37, between the PVD device 37 and the CVD device 38, between the CVD device 38 and the second heating device 39, between the second heating device 39 and the etching device 40, between the etching device 40 and the CVD device 41, between the CVD device 41 and the second heating device 42, between the second heating device 42 and the wind-up etching device 43, and between the additional treatment device 44 and the wind-up section 34, respectively.

The sealing function between the adjacent process sections, e.g., the sealing function in the first heating device 36, will now be described with reference to FIG. 2. Incidentally, the process sections other than the first heating device 36 also perform a similar sealing function.

As shown in the drawing, a casing 51 is filled with a process chamber gas 52. A process roll 54 equipped with a heating device 53 and a heater 55 are arranged inside the casing 51, and the casing 51 is exhausted through an exhaust port 56. It should be noted that the surface roughness of the process roll 54 is set at 0.3 µm or less in order to maintain uniform the temperature of the flexible substrate 32, thereby making the contact heat transmission uniform. Four sealing rolls 57 are arranged apart from each other in an exhaust section 45a on the upstream side (the upper side in the drawing) of the first heating device 36. Also, four upper side sealing bars 58 are arranged upstream of the four sealing rolls 57, and four lower side sealing bars 60 are arranged downstream of the four sealing rolls 57. As shown in the drawing, the flexible substrate 32 is allowed to pass through the clearance between the sealing roll 57 and the upper side sealing bar 58.

The flexible substrate 32 passes through the clearance between the sealing roll 57 and the upper side sealing bar 58 so as to reach the process roll 54 through a floating roll 61a serving to determine the fine positioning of the flexible substrate 32. The floating roll 61a is set movable in a direction perpendicular to the main surface of the flexible substrate 32, i.e., in the direction denoted by an arrow X in the drawing. The exhaust section 45a is divided into three chambers by the sealing roll 57, the upper side sealing bar 58 and the lower side sealing bar 60.

FIG. 3 shows the clearance between the upper side sealing bar 58 and the sealing roll 57 and the clearance between the sealing roll 57 and the lower side sealing bar 60. The clearance L₁ between the upper side sealing bar 58 and the upper surface of the flexible substrate 32 is set at 0.15 mm and, thus, the clearance between the upper side sealing bar 58 and the sealing roll 57 is set equal to the sum of the clearance L₁, i.e., 0.15 mm, and the thickness of the flexible substrate 32. On the other hand, the lower side clearance L₂ between the lower side sealing bar 60 and the sealing roll 57 is set at 0.15 mm. As a result, it is possible to suppress the entry of the process gas into the clearances L₁ and L₂. Also, the flexible substrate 32 passing through the clearance between the upper side sealing bar 58 and the sealing roll 57 is not brought into contact with the upper side sealing bar 58. Also, deflector rolls 59 are arranged adjacent to the prescribed upper side sealing bars 58 on the upper side of the flexible substrate 32 so as to prevent the flexible substrate 32 from being brought into contact with the upper side sealing bars 58. It should be noted that these deflector rolls 59 serve to hold the flexible substrate 32 on the side of the sealing rolls 58.

Each exhaust chamber is provided with an exhaust port 67. The apparatus is constructed such that the process chamber gas 52, which is capable of entering the exhaust chamber on the side of the process chamber and the central exhaust chamber, is incapable of entering the exhaust chamber on the front stage and the exhaust chamber on the rear stage. Also, the apparatus is capable of evacuating the waste process chamber gas to the outside through the exhaust ports 67.

The flexible substrate 32 reaching the process roll 54 is heated by the heating device 53 to the temperature required for the processing. Also, the gas required for the processing or a metal vapor is released from the process device 36, and the unnecessary gas or the like is evacuated to the outside through the exhaust port 56.

An exhaust section 45b downstream of the first heating device 36 (the right side in the drawing) is substantially equal in construction to the exhaust section 45a upstream of the first heating section 36.

To be more specific, four sealing rolls 62 are arranged apart from each other on the downstream side in the exhaust section 45b. Four sealing bars 63 are arranged on the upper side of the sealing rolls 62, and four lower side sealing bars 65 are arranged on the lower side of the sealing rolls 62. Further, the flexible substrate 32 passes through the clearance between the sealing rolls 62 and the upper side sealing bars 63.

The flexible substrate 32 passes through a floating roll 61b serving to perform a fine positioning and, then, through the clearance between the sealing rolls 62 and the upper sealing bars 63 so as to reach the next process chamber. It should be noted that the exhaust section 45b is divided into three chambers by the sealing rolls 62, the upper side sealing bars 63 and the lower side sealing bars 65.

The clearance between the upper side sealing bar 63 and the upper surface of the flexible substrate 32 is set at 0.15 mm and, thus, the upper side clearance between the upper side sealing bar 63 and the sealing roll 62 is set equal to the sum of the clearance between the upper side sealing bar 63 and the upper surface of the flexible substrate 32, i.e., 0.15 mm, and the thickness of the flexible substrate 32. On the other hand, the lower clearance between the sealing roll 62 and the lower side sealing bar 65 is set at 0.15 mm. Therefore, it is possible to suppress the entry of the process gas into the upper and lower clearances. In addition, the flexible substrate 32 passing through the upper clearance is prevented from being brought into contact with the upper side sealing bar 63. Also, deflector rolls 64 are arranged adjacent to the prescribed upper side sealing bars 63 so as to prevent the flexible substrate 32 from being brought into contact with the upper side sealing bars 63. These deflector rolls 64 serve to hold the flexible substrate 32 toward the sealing rolls 62.

Each exhaust chamber is provided with three exhaust ports 68, and the apparatus is constructed such that the process chamber gas 52, which is capable of entering the exhaust chamber on the side of the process chamber and the central exhaust chamber, is incapable of entering the exhaust chamber on the front stage and the exhaust chamber on the rear stage. In addition, the apparatus is capable of discharging the waste process chamber gas 52 to the outside.

A control sensor 69 is arranged on the downstream side of the floating roll 61b. The control sensor 69 serves to maintain constant the moving speed of the flexible substrate 32 within each process section while measuring the moving speed of the flexible substrate 32 and to prevent a nonuniform excessive tension from being applied to the flexible substrate 32. Incidentally, a reference numeral 70 shown in FIG. 2 denotes a casing, and reference numerals 71a and 71b denote the sealing section casings between the adjacent casings 70. Also, the flexible substrate 32 is driven at a constant moving speed within each process section while the moving speed of the flexible substrate 32 is being measured by the control sensor 69 so as to prevent a nonuniform excessive tension from being applied to the flexible substrate 32.

The function and effect of the apparatus for continuously forming a semiconductor film on a flexible substrate, which is constructed as described above, will now be described.
1) As described above, the apparatus of the present invention for continuously forming a semiconductor film on a flexible substrate is constructed such that the pay-off section 31 held under a clean atmosphere free from dust is arranged at one end portion of the apparatus, and a wind-up section 34 held under a clean atmosphere free from dust is arranged at the other end portion of the apparatus. In the apparatus of this particular construction, the processing such as the deposition of a film on the flexible substrate 32, the heat treatment applied to the deposited film and the etching applied to the deposited film are carried out between the pay-off section 31 and the wind-up section 34.
   It should be noted that the first heating device 36 constitutes the first process section, and the components of the air atmosphere attached to the flexible substrate are released and discharged to the outside. As a result, the unnecessary gaseous components are prevented from entering the process chamber.
2) The system consisting of the CVD device, the second heating device and the etching device is repeatedly arranged twice to n-times in accordance with the number of semiconductor films laminated on the flexible substrate 32. Also, the laminate structure of the semiconductor films is subjected to an additional processing in the final stage and, then, the flexible substrate having the laminate structure of the semiconductor films formed thereon is wound up. What should be noted is that the flexible substrate 32 is not exposed to the air atmosphere after start-up of the processing. It follows that a series of processings can be carried out while preventing the laminate structure of the semiconductor films formed on the flexible substrate 32 from being contaminated with air.
3) The control sensor 69 is arranged downstream of the floating roll 61b. Therefore, it is possible to drive the flexible substrate 32 at a constant moving speed within each process section while measuring the moving speed of the flexible substrate 32 with the control sensor 69. It follows that it is possible to prevent a nonuniform excessive load from being applied to the flexible substrate 32. Also, it is possible to prevent an excessive load from being generated in the flexible substrate 32 by applying a constant speed control through all the stages, and the process position can be determined by finely adjusting the position of the floating roll 61b arranged within each process chamber. Incidentally, the determination of the position is carried out by using a microscope device (not shown).
4) The upper clearance between the upper side sealing bar and the sealing roll is set equal to the sum of 0.15 mm and the thickness of the flexible substrate 32, and the lower clearance between the lower side sealing bar and the sealing roll is set at 0.15 mm, which is sufficiently small. As a result, it is possible to suppress the entry of the process gas into the upper and lower clearances. In addition, even where the flexible substrate 32 passes through the upper clearance, the flexible substrate 32 can be prevented from being brought into contact with the upper side sealing bar.
5) The deflector 59 (or 64) is arranged adjacent to the upper side sealing bar 58 (or 63) and, thus, is capable of holding the flexible substrate 32 toward the sealing roll 57 (or 62). It follows that the flexible substrate 32 is prevented from being brought into contact with the upper side sealing bar 58 (or 63).
6) The exhaust ports 67, 68 are arranged in each exhaust chamber. Therefore, the process chamber gas 52, which is capable of entering the exhaust chamber on the side of the process chamber and the central process chamber, is incapable of entering the exhaust chamber on the front stage and the exhaust chamber on the rear stage.
7) Since the heating device 53 is arranged along the inner circumferential surface of the process roll 54, the process roll 54 can be heated uniformly. Also, the surface roughness of the process roll 54 is s-et at 0.3 µm or less in order to maintain uniform the temperature of the flexible substrate 32, thereby making uniform the contact heat transmission. It follows that it is possible to heat the flexible substrate 32 passing along the outer circumferential surface of the process roll 54 to the temperature required for the processing.
8) The energy, gas or metal vapor required for the processing is released from the process device 36, and the unnecessary gas or the like after the processing is discharged to the outside through the exhaust port 56. Therefore, it is possible to decrease the amount of the exhaust gas within the exhaust chamber.
9) Since the process chambers differ from each other in the process temperature, the amount of the thermal expansion of the flexible substrate 32 in a certain process chamber differs from that in another process chamber. However, the floating rolls 61a, 61b, which are movable in directions perpendicular to the transfer direction of the flexible substrate 32, i.e., in the directions denoted by arrows X and Y, are arranged in the upper portion of the process device 36 in the embodiment described above so as to prevent the change in the position determination.
10) The flexible substrate 32 is formed of a polyimide film. Therefore, the flexible substrate 32 is excellent in ductility and in heat resistance or heat insulating properties. It follows that the flexible substrate 32 is adapted for the process such as a local heating.

Incidentally, in the embodiment described above, the flexible substrate is formed of a polyimide film. However, the flexible substrate is not limited to a polyimide film. Alternatively, a thin sheet such as a stainless steel sheet can also be used as the flexible substrate.

Also, in the embodiment described above, the exhaust section includes three exhaust chambers. However, it is not absolutely necessary for the exhaust section to include three exhaust chambers. For example, it is possible for the exhaust section to include only one exhaust chamber, depending on the allowable amount of impurity gas contained in the process gas. By contraries, it is possible for the exhaust section to include four or five exhaust chambers in the case where the allowable amount of the impurity gas is severe.

## Claims

1. An apparatus for forming a semiconductor film on a flexible substrate, **characterized by** comprising:
a supply device (31) for supplying a flexible substrate (32);
a recovery device (34) for recovering the flexible substrate (32);
a first heating device (36) arranged between said supply device (31) and said recovery device (34) for heating said substrate (32) ;
a PVD device (37) for depositing a film on said substrate (32) by a physical vapor deposition;
a CVD device (38) for depositing a film on said substrate (32) by a chemical vapor deposition;
a second heating device (39) for heating the material deposited on said substrate (32); and
an etching device (40) for etching the material deposited on said substrate (32),
wherein said CVD device (38), (40), said second heating device (39), (42) and said etching device (40), (43) are repeatedly arranged within a casing held under a prescribed atmosphere.

2. The apparatus for forming a semiconductor film on a flexible substrate according to claim 1, **characterized in that** said second heating device (39), (42) is a radiation heat type or laser type heating device, and said etching device (40), (43) is an optical etching device.

3. The apparatus for forming a semiconductor film on a flexible substrate according to any one of claim 1 and claim 2, **characterized in that** an exhaust chamber is arranged between said first heating device (36) and said PVD device (37), between said PVD device (37) and said CVD device (38), (41), between said CVD device (38), (41) and said second heating device (39), (42), and between said second heating device (39), (42) and said etching device (40), (43).

4. The apparatus for forming a semiconductor film on a flexible substrate according to any one of claim 1 to claim 3, **characterized in that** a floating roll (61a), (61b) for determining the position of said flexible substrate (32) is arranged between said first heating device (36) and said PVD device (37), between said PVD device (37) and said CVD device (38), (41), between said CVD device (38), (41) and said second heating device (39), (42), and between said second heating device (39), (42) and said etching device (40), (43).

5. The apparatus for forming a semiconductor film on a flexible substrate according to any one of claim 1 to claim 4, **characterized in that** said flexible substrate (32) is formed of any of a thin metal sheet and a thin plastic sheet.

6. The apparatus for forming a semiconductor film on a flexible substrate according to any one of claim 1 to claim 5, **characterized in that** a roll (54) for applying a processing to said flexible substrate is arranged in each of the chambers housing said first heating device (36), said PVD device (37), said CVD device (38), (41), said second heating device (39), (42), and said etching device (40), (43), and the surface roughness of said roll (54) is not larger than 0.3 µm.
